# EUROPEAN PATENT APPLICATION

(11) **EP 4 506 982 A1**
(43) Date of publication of application: **12.02.2025**
(21) Application number: 23780992.6
(22) Date of filing: 30.03.2023
(51) Int. Cl.: H01L 21/308, C23F 1/30, H01L 21/306

(54) **LUBRICANT FOR FILTRATION CONTAINING ONIUM IONS**

(30) Priority: 31.03.2022 JP 2022061376
(71) Applicant: TOKUYAMA CORPORATION, Yamaguchi 745-8648 (JP)
(72) Inventor: SATO, Tomoaki, Shunan-shi, Yamaguchi 745-8648 (JP); KIKKAWA, Yuki, Shunan-shi, Yamaguchi 745-8648 (JP); SAITO, Kohei, Shunan-shi, Yamaguchi 745-8648 (JP)
(74) Representative: Jones, Nicholas Andrew
(86) International application number: PCT/JP2023/013385
(87) International publication number: WO 2023/190984

(57) **Abstract**

Provided is, for example, a lubricant for filtration which has a surface tension of 60-75 mN/m and which contains onium ions. Also provided are a composition for polishing which contains onium ions and hypohalous acid ions, a metal recovery agent which contains onium ions coordinated to metal oxide ions or metal hydroxide ions, and the like.

## Description

### Technical Field

The present invention relates to a smoothing agent for filtration, a composition for polishing, and the like in which a decrease in an onium salt during filtration is prevented in a manufacturing process of a semiconductor device.

### Background Art

In a semiconductor device, a wiring layer is formed for the purpose of taking out an electrical signal generated by a transistor to the outside. As semiconductor devices are made finer year by year, use of a material with low electromigration resistance or high resistance causes a decrease in reliability of the semiconductor device and/or inhibition of high-speed operation. This leads to a desire for a material with high electromigration resistance and a low resistance value as a wiring material.

Examples of such materials include aluminum and copper, which have been used to date, and tungsten, cobalt, molybdenum, and ruthenium, which have recently been studied. Forming a wiring layer in a semiconductor device includes a step of processing a wiring material, and dry or wet etching is used in this step.

In wet-etching a wiring material, the dissolution rate of the wiring material, that is, the etching rate, is important. A wiring material with a high etching rate can be dissolved in a short time, and thus this can increase the number of wafers treated per unit time.

In addition, a problem peculiar to the wiring material occurring during etching may also happen. For example, ruthenium when wet-etched under alkaline conditions dissolves as RuO₄⁻, RuO₄²⁻, and/or the like in the treatment liquid. RuO₄⁻ and RuO₄²⁻ change to RuO₄ in the treatment liquid, and a portion of it is gasified and released into the gas phase. RuO₄ is strongly oxidizing and thus is not only harmful to the human body but also easily reduced to produce RuO₂ particles. In general, particles lead to a decrease in yield, thus causing a serious problem in a semiconductor formation process. Thus, preventing the generation of RuO₄ gas is very important.

Patent Document 1 proposes a treatment liquid for a semiconductor wafer, the liquid containing a hypobromite ion, exhibiting an excellent etching rate and stability of the etching rate, and capable of preventing generation of RuO₄ gas.

### Prior Art Documents

### Patent Document

Patent Document 1: WO 2021/059666

### Summary of Invention

### Technical Problem

A wet etching apparatus for a semiconductor wafer is equipped with a filter with a fine mesh of several nm to several tens of nm for the purpose of removing particles in a treatment liquid. Adding an onium ion to a semiconductor treatment liquid and passing the liquid through a filter was found to reduce the onium ion concentration. This was found to greatly reduce effects of preventing surface roughening during etching and RuO₄ gas.

In addition, in a wet etching step of a semiconductor wafer, usually, for the purpose of reducing the manufacturing cost, a treatment liquid once used for etching is often circulated and reused. However, reuse of the treatment liquid described in Patent Document 1 was found to reduce the etching rate.

Thus, an object of the present invention is to provide a smoothing agent for filtration which prevents a decrease in the onium ion concentration in a treatment liquid due to filtration with a filter. Furthermore, another object of the present invention is to provide a smoothing agent for filtration which allows etching a wiring material, in particular ruthenium, contained in a semiconductor wafer at a sufficient rate by using the smoothing agent for filtration as a semiconductor treatment liquid, and is not only capable of reducing the generation of RuO₄ gas during etching but also prevents a decrease in etching characteristics by reuse.

### Solution to Problem

The present inventors have conducted diligent research to solve the above problems and found that a decrease in the concentration of an onium ion can be prevented by controlling the surface tension of a smoothing agent for filtration. This has led to the result that the surface smoothness of a wiring material is maintained and RuO₄ gas can be generated. Furthermore, the present inventors have also found that a decrease in etching characteristics during reuse of a treatment liquid containing a smoothing agent for filtration can be prevented by appropriate control of the type and concentration of an oxidizing agent that can be contained in the smoothing agent for filtration and the type and concentration of an onium ion in addition to the control of the surface tension and completed the present invention.

That is, the present invention is configured as follows.

Aspect 1. A smoothing agent for filtration containing an onium ion, in which a surface tension at 25°C is 60 mN/m or more and 75 mN/m or less.

Aspect 2. The smoothing agent for filtration according to aspect 1, in which the onium ion is one or more selected from the group consisting of onium ions represented by formula (1) to formula (6): 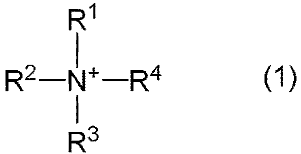 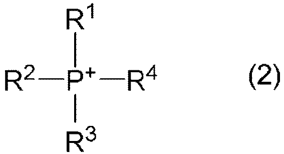 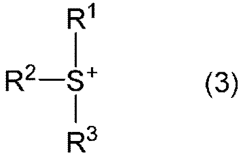 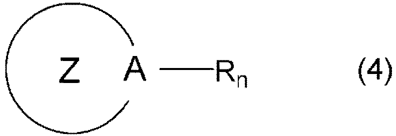 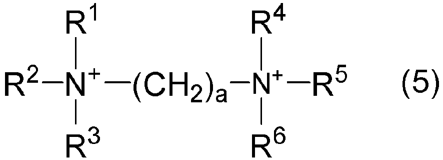 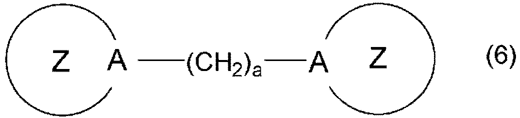 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally containing a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

Aspect 3. The smoothing agent for filtration according to aspect 1 or 2, in which a concentration of the onium ion is 1 mass ppm or more and 10000 mass ppm or less.

Aspect 4. The smoothing agent for filtration according to any one of aspects 1 to 3, further containing 0.001 mol/L or more and 0.20 mol/L or less of a hypohalite ion.

Aspect 5. The smoothing agent for filtration according to any one of aspects 1 to 4, further containing a periodate ion.

Aspect 6. The smoothing agent for filtration according to any one of aspects 1 to 5, in which the smoothing agent for filtration is used in treatment a semiconductor wafer, and the semiconductor wafer contains at least one metal selected from Ru, Rh, Ti, Ta, Co, Cr, Hf, Os, Pt, Ni, Mn, Cu, Zr, La, Mo, and W.

Aspect 7. The smoothing agent for filtration according to any one of aspects 1 to 5, in which the semiconductor wafer contains Ru.

Aspect 8. A method of etching a semiconductor wafer, the method including a step of bringing the smoothing agent for filtration according to any one of aspects 1 to 7 into contact with a semiconductor wafer.

Aspect 9. A method of manufacturing a semiconductor device, the method including steps of:
filtering the smoothing agent for filtration according to any one of aspects 1 to 7; and
subjecting the smoothing agent for filtration after the filtration to etching of a semiconductor wafer.

Aspect 10. The method of manufacturing a semiconductor device according to aspect 9, the method including the step of filtering the smoothing agent for filtration a plurality of times.

Aspect 11. A regeneration method for a used semiconductor treatment liquid, the method including a step of adding the smoothing agent for filtration according to any one of aspects 1 to 7 to a used semiconductor treatment liquid.

Aspect 12. A composition for polishing containing:
one or more selected from the group consisting of onium ions represented by formula (1) to formula (6) below; and
a hypohalite ion: 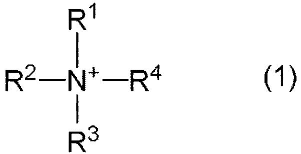 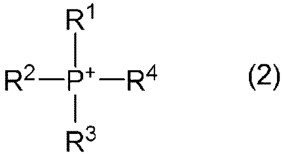 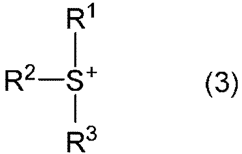 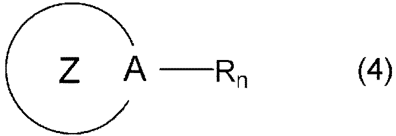 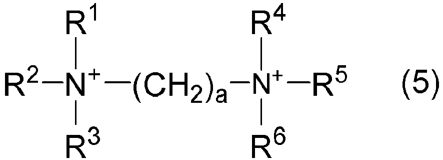 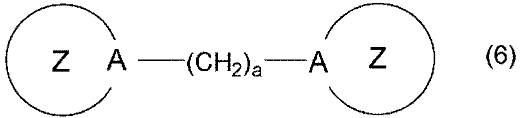
where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally containing a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

Aspect 13. A composition for polishing containing the smoothing agent for filtration according to any one of aspects 4 to 7.

Aspect 14. A method of polishing a semiconductor wafer, the method including supplying a composition for polishing to a polishing pad comprising an abrasive grain or a polishing pad comprising no abrasive grain, and bringing a polishing target surface of a semiconductor wafer into contact with the polishing pad to polish the polishing target surface by relative motion between the polishing target surface and the polishing pad, in which the composition for polishing according to aspect 12 or 13 is used.

Aspect 15. A metal recovery agent containing an onium ion to coordinate with a metal oxide ion or a metal hydroxide ion.

Aspect 16. The metal recovery agent according to claim 15, in which the onium ion is one or more selected from a phosphonium ion and an ammonium ion.

Aspect 17. A method of recovering a metal from a used semiconductor treatment liquid, the method including a step of adding the metal recovery agent according to claim 15 or 16 to a used semiconductor treatment liquid.

### Effects of Invention

According to an embodiment of the present invention, the decrease in the concentration of an onium salt in a filtration step can be prevented by controlling the surface tension of the smoothing agent for filtration containing an onium salt. Thus, the use of this smoothing agent for filtration as a semiconductor treatment liquid can maintain good surface smoothness upon etching and prevent the generation of RuO₄ gas. In addition, this allows filtration using a fine filter and thus can improve the yield of semiconductor wafers by removing particles in the treatment liquid. Furthermore, the decrease in etching characteristics during reuse of the treatment liquid can be prevented by appropriate control of the types and concentrations of an oxidizing agent and an onium ion in addition to the control of the surface tension, thus allowing a significant cost reduction in manufacturing a semiconductor wafer.

### Brief Description of Drawings

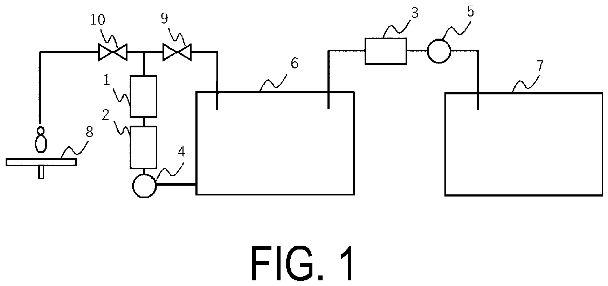

FIG. 1 is a diagram schematically illustrating equipment used in an etching step in a method of manufacturing a semiconductor device.

### Description of Embodiments

### (Smoothing Agent for Filtration)

A smoothing agent for filtration according to an embodiment of the present invention is characterized by containing an onium ion and having a surface tension of 60 mN/m or more and 75 mN/m or less. The onium ion interacts with the metal surface of a semiconductor wafer, and this makes it possible to prevent roughening of the metal surface. In addition, in the case where ruthenium is contained in the semiconductor wafer, the onium ion interacts with RuO₄⁻ and/or RuO₄²⁻ generated during etching of ruthenium, and this can prevent the generation of RuO₄ gas and RuO₂ particles otherwise generated concomitantly. Thus, the smoothing agent for filtration according to an embodiment of the present invention can be suitably used as it is as a semiconductor treatment liquid in a step, such as etching, residue removal, washing, and CMP, in a semiconductor manufacturing process.

As described above, the onium ion contained in the smoothing agent for filtration according to an embodiment of the present invention plays various roles, and the surface tension of the smoothing agent for filtration is a key to highly maintaining these effects. That is, with the surface tension of the smoothing agent for filtration of less than 60 mN/m, the onium ion contained in the smoothing agent for filtration would be easily removed by a filtration step, and thus this would make it difficult to maintain the good surface smoothness and the effect of preventing the RuO₄ gas generation as described above. One method of increasing the surface tension is a method of adding a salt containing an anion with a high degree of hydration. Adding an anion with a high degree of hydration inhibits the neutralization of the charge of the onium ion by the anion and maintains the electrical repulsion between the onium ions, and thus can increase the surface tension. Examples of the anion with a high degree of hydration include a fluoride ion, a chloride ion, and a bromide ion. On the other hand, in a case where an oxidizing agent described below is contained in the smoothing agent for filtration according to an embodiment of the present invention, the salt and the oxidizing agent may react with each other to reduce the stability of the oxidizing agent, or the salt at a high concentration may inhibit etching. For such a reason, the surface tension is preferably 75 mN/m or less.

The filtration step will now be described. In manufacturing a semiconductor wafer, adhesion of particles to a wafer leads to a decrease in the yield, and thus the treatment liquid is filtered for the purpose of removing particles in the treatment liquid. A state-of-the-art semiconductor wafer has a wiring width as fine as several nm to several tens of nm, and thus a filter used in the filtration step is also required to have a similar pore size. However, the filter with smaller pore size facilitates the adsorption and removal of the onium salt or the onium ion. This would reduce the onium ion concentration in the treatment liquid and thus would impair the function as the treatment liquid described above.

However, such a decrease in the concentration of the onium ion can be avoided by controlling the surface tension of the smoothing agent for filtration as a semiconductor treatment liquid. Specifically, the surface tension of water is about 73 mN/m at 25°C, and bringing the surface tension of the smoothing agent for filtration close to this value makes it possible to prevent the adsorption of the onium salt or the onium ion to the filter. That is, the adsorption of the onium salt or the onium ion to the filter is prevented by controlling the surface tension of the smoothing agent for filtration to 60 mN/m or more and 75 mN/m or less, and the smoothing agent for filtration can be used as the treatment liquid without impairing its function. For such a reason, the surface tension is 60 mN/m or more and 75 mN/m or less, preferably 68 mN/m or more and 75 mN/m or less, and most preferably 71 mN/m or more and 73 mN/m or less. The surface tension in the present specification is a value at 25°C. The surface tension of the smoothing agent for filtration can be increased for example, by reducing the concentration of the onium salt to be added, changing the type of salt containing an anion with a high degree of hydration, and/or increasing the concentration of such a salt, thus allowing the surface tension to fall within an appropriate range. The surface tension can be adjusted in the same manner in other embodiments described below.

### (Onium Ion)

The surface tension is affected by the onium ion contained in the smoothing agent for filtration according to an embodiment of the present invention. Thus, appropriate selection of the type and concentration of the onium ion makes it possible to maintain the surface tension in an appropriate range. To maintain the surface tension in a preferred range, one or more selected from the group consisting of onium ions with structures represented by formulas (1) to (6) below are preferably selected. 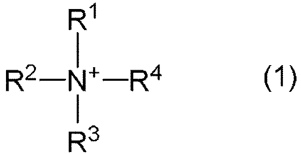 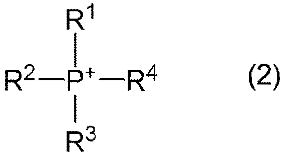 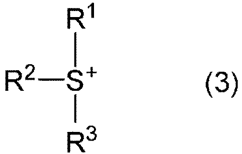 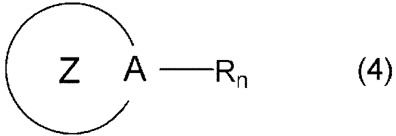 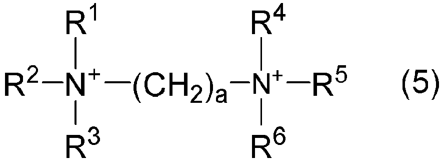 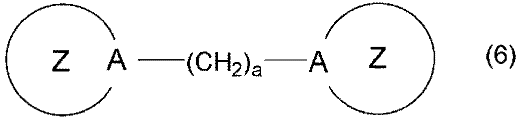 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine.
Examples of the counter anion to the onium ion include a fluoride ion, a chloride ion, a bromide ion, an iodide ion, a hydroxide ion, a nitrate ion, a phosphate ion, a sulfate ion, a hydrogensulfate ion, a methanesulfate ion, a perchlorate ion, a chlorate ion, a chlorite ion, a hypochlorite ion, an orthoperiodate ion, a metaperiodate ion, an iodate ion, an iodite ion, a hypoiodite ion, an acetate ion, a carbonate ion, a hydrogen carbonate ion, a fluoroborate ion, or a trifluoroacetate ion,
A is an ammonium ion or a phosphonium ion,
Z is an aromatic group or alicyclic group optionally containing a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

With a longer chain length, the hydrocarbon group represented by R in the formulas has higher hydrophobicity. Thus, the surface tension tends to decrease in the smoothing agent for filtration containing an onium ion having a longer-chain hydrocarbon group. On the other hand, with too short a hydrocarbon chain, the effects of the onium ion, that is, an improvement in surface smoothness and the effect of preventing RuO₄ gas, would be limited. For such a reason, the carbon number of the hydrocarbon group is preferably within the range described above.

The concentration of the onium ion in the smoothing agent for filtration according to an embodiment of the present invention is preferably 1 mass ppm or more and 10000 mass ppm or less. With too small an amount of the onium ion to be added, in a case of use as a semiconductor treatment liquid, not only interaction with RuO₄⁻ and/or the like would weaken and the effect of preventing RuO₄ gas would decrease but also the amount of the onium ion adhered to the metal surface during etching would be insufficient. Thus, the surface smoothness would tend to decrease. On the other hand, with too large an addition amount, the amount of the onium ion adsorbed to the metal surface would be too large, and this would reduce the etching rate. In addition, in the case where the smoothing agent for filtration contains an oxidizing agent, the oxidizing agent and the onium ion may react with each other and may cause a decrease in the concentration of the oxidizing agent. Thus, the smoothing agent for filtration according to an embodiment of the present invention contains the onium ion in an amount of preferably 1 mass ppm or more and 10000 mass ppm or less, more preferably 10 mass ppm or more and 5000 mass ppm or less, and even more preferably 50 mass ppm or more and 2000 mass ppm or less. In the case of adding an onium ion, only one type can be added, or two or more types can be added in combination. Also in the case of containing two or more types of onium ions, with the total concentration of the onium ions in the above concentration range, the generation of RuO₄ gas can be effectively prevented.

Examples of such onium ions include a chlorocholine ion, a trans-2-butene-1,4-bis(triphenylphosphonium ion), a 1-hexyl-3-methylimidazolium ion, an allyltriphenylphosphonium ion, a tetraphenylphosphonium ion, a benzyltriphenylphosphonium ion, a methyltriphenylphosphonium ion, a (2-carboxyethyl)triphenylphosphonium ion, a (3-carboxypropyl)triphenylphosphonium ion, a (4-carboxybutyl)triphenylphosphonium ion, a (5-carboxypentyl)triphenylphosphonium ion, a cinnamyltriphenylphosphonium ion, a (2-hydroxybenzyl)triphenylphosphonium ion, a (1-naphthylmethyl)triphenylphosphonium ion, a butyltriphenylphosphonium ion, a (tert-butoxycarbonylmethyl)triphenylphosphonium ion, an allyltriphenylphosphonium ion, a (3-methoxybenzyl)triphenylphosphonium ion, a (methoxymethyl)triphenylphosphonium ion, a (1-ethoxy-1-oxopropan-2-yl)triphenylphosphonium ion, a (3,4-dimethoxybenzyl)triphenylphosphonium ion, a methoxycarbonylmethyl(triphenyl)phosphonium ion, a (2,4-dichlorobenzyl)triphenylphosphonium ion, a (2-hydroxy-5-methylphenyl)triphenylphosphonium ion, a (4-chlorobenzyl)triphenylphosphonium ion, a (3-chloro-2-hydroxypropyl)trimethylammonium ion, a methacroylcholine ion, a benzoylcholine ion, a benzyldimethylphenylammonium ion, a (2-methoxyethoxymethyl)triethylammonium ion, a carbamylcholine ion, a 1,1'-difluoro-2,2'-bipyridinium bis(tetrafluoroborate), a benzyltributylammonium ion, a trimethylphenylammonium ion, a 5-azoniaspiro[4.4]nonane ion, a tributylmethylammonium ion, a tetrabutylammonium ion, a tetrapentylammonium ion, a tetrabutylphosphonium ion, a diallyldimethylammonium ion, a 1,1-dimethylpiperidinium ion, a (2-hydroxyethyl)dimethyl(3-sulfopropyl)ammonium hydroxide, a 3-(trifluoromethyl)phenyltrimethylammonium ion, a 1,1'-(decane-1,10-diyl)bis[4-aza-1-azoniabicyclo[2.2.2]octane] diion, a (3-bromopropyl)trimethylammonium ion, vinylbenzyltrimethylammonium ion, an allyltrimethylammonium ion, a trimethylvinylammonium ion, a choline ion, a β-methylcholine ion, and a triphenylsulfonium ion. The onium ion is preferably one or more types selected from the group consisting of benzyldimethylphenylammonium ion, 1-ethoxy-1-oxopropan-2-yl)triphenylphosphonium ion, 1,1'-(decan-1,10-diyl)bis[4-aza-1-azoniabicyclo[2.2.2]octane] diion, butyltriphenylphosphonium ion, (2-carboxyethyl)triphenylphosphonium ion, (3-carboxypropyl)triphenylphosphonium ion, (4-carboxybutyl)triphenylphosphonium ion, allyltriphenylphosphonium ion, tetraphenylphosphonium ion, and benzyltriphenylphosphonium ion.

As described above, the effects of the onium ion include prevention of surface roughening during etching and prevention of RuO₄ gas. In addition, the onium ion also has an effect of increasing the number of times of reuse when the smoothing agent for filtration is used as a semiconductor treatment liquid. In a semiconductor wafer manufacturing plant, a used treatment liquid is commonly recycled and reused from the viewpoint of cost reduction. In this case, for example, in etching, a metal dissolves in the treatment liquid, and thus the composition of the treatment liquid differs before and after use. For example, in etching of ruthenium with a hypobromite ion, ruthenium dissolves as RuO₄⁻ under alkaline conditions. In this case, when this RuO₄⁻, or RuO₄²⁻ and/or RuO₄ produced by the change of RuO₄⁻ reacts with the hypobromite ion, the concentration of the hypobromite ion, which is a chemical species effective for etching, decreases. Thus, the etching rate decreases with the increase in the number of times of reuse of the treatment liquid and with the increase in the reuse time.

However, blending the smoothing agent for filtration with an onium ion may improve the stability during reuse in the case of using the smoothing agent for filtration as a semiconductor treatment liquid. That is, RuO₄⁻ and/or the like actively reacts with the onium ion, and this makes it possible to prevent the reaction of RuO₄⁻ and/or the like with a hypobromite ion. The onium ion that can be used for such a purpose is preferably a phosphonium ion. An ammonium ion poses a concern that reaction with a hypobromite ion produces an amine, and thus this amine may decompose the hypobromite ion. In addition, a phosphonium ion generally has a larger molecular size than an ammonium ion and easily forms an ion pair with RuO₄⁻ generated by dissolution, thus binds RuO₄⁻ and also provides an effect of preventing the reaction of RuO₄⁻ with a hypobromite ion.

Examples of such an onium ion include an allyltriphenylphosphonium ion, a tetraphenylphosphonium ion, a trans-2-butene-1,4-bis(triphenylphosphonium ion), a benzyltriphenylphosphonium ion, a tetrabutylphosphonium ion, a tributylhexylphosphonium ion, a heptyltriphenylphosphonium ion, a cyclopropyltriphenylphosphonium ion, a (bromomethyl)triphenylphosphonium ion, and a (chloromethyl)triphenylphosphonium ion.

### (Hypobromite Ion and Hypochlorite Ion)

The smoothing agent for filtration according to an embodiment of the present invention can contain an oxidizing agent. Blending the smoothing agent for filtration with an oxidizing agent makes it possible to add a function of removing metal contained in a semiconductor wafer and thus to use the smoothing agent as it is as a semiconductor treatment liquid. In addition, the smoothing agent can be suitably used in steps, such as etching and cleaning, of a semiconductor wafer containing a metal. The type of oxidizing agent is not particularly limited, but examples include hydrogen peroxide, ozone, hypochlorous acid, chlorous acid, chloric acid, perchloric acid, hypobromous acid, bromous acid, bromic acid, perbromic acid, hypoiodous acid, iodous acid, iodic acid, periodic acid, their salts, and ions produced by dissociation of these salts; and furthermore, one or more selected from the group consisting of hydrogen peroxide, ozone, fluorine, chlorine, bromine, iodine, permanganates, chromates, dichromates, and cerium salts. Among these, in terms of strong oxidizing power, stability, and suitability for use in semiconductor applications, a hypobromite ion, a hypochlorite ion, or a periodate ion is preferred, and a hypobromite ion is most preferred. The periodate ion is an orthoperiodate ion or a metaperiodate ion.

For example, in adding a hypobromite ion or a periodate ion to the smoothing agent for filtration according to an embodiment of the present invention, the concentration of the ion is not particularly limited as long as it does not depart from the object of the present invention, but the concentration of either ion is preferably 0.001 mol/L or more and 0.20 mol/L or less. With the concentration less than 0.001 mol/L, the rate of etching metal would be low, reducing practicality. On the other hand, with the concentration higher than 0.20 mol/L, a hypobromite ion would be easily decomposed, and thus the etching rate of metal would be less likely to be stable. For stable etching of metal at a sufficient rate, the concentration of the hypobromite ion is preferably 0.001 mol/L or more and 0.20 mol/L or less, more preferably 0.005 mol/L or more and 0.20 mol/L or less, and most preferably 0.01 mol/L or more and 0.10 mol/L or less.

The mechanism of etching metal with an oxidizing agent will be described by taking an example where the oxidizing agent is a hypobromite ion and the metal is ruthenium. A hypobromite ion is presumed to dissolve ruthenium in the smoothing agent for filtration by oxidizing ruthenium to RuO₄, RuO₄⁻, or RuO₄²⁻ in the smoothing agent for filtration. Dissolving ruthenium as RuO₄⁻ or RuO₄²⁻ makes it possible to reduce the amount of RuO₄ gas to be generated and prevent the generation of RuO₂ particles. To dissolve ruthenium as RuO₄⁻ or RuO₄²⁻, the pH of the smoothing agent for filtration is preferably alkaline, and the pH of the smoothing agent for filtration is more preferably 8 or more and 14 or less, even more preferably 12 or more and 14 or less, and most preferably 12 or more and less than 13. Ruthenium dissolves as RuO₄⁻ or RuO₄²⁻ in the smoothing agent for filtration with a pH of 12 or more and less than 13, and thus this can significantly reduce the amount of RuO₄ gas to be generated and can prevent the generation of RuO₂ particles. On the other hand, in the smoothing agent for filtration with a pH less than 8, ruthenium would be easily oxidized to RuO₂ and/or RuO₄, and thus this would increase the amount of RuO₂ particles and tend to increase the amount of RuO₄ gas to be generated. In addition, ruthenium would be less likely to dissolve in the smoothing agent for filtration with a pH higher than 14, making it difficult to obtain a sufficient ruthenium etching rate, and thus reducing the production efficiency in semiconductor manufacturing.

One or plurality of oxidizing agents can be contained in the smoothing agent for filtration according to an embodiment of the present invention. Containing a plurality of oxidizing agents may be able to improve the stability when the smoothing agent for filtration is reused. For example, in the smoothing agent containing a hypobromite ion as a first oxidizing agent, a hypobromite ion consumed in etching a metal loses its oxidizing power and changes into a bromide ion. In this case, the greater the amount changing into a bromide ion, the more the etching rate decreases when the smoothing agent is used as a semiconductor treatment liquid. In a semiconductor wafer manufacturing plant, a treatment liquid is commonly recycled and reused from the viewpoint of cost reduction. However, decrease in the etching rate due to the reuse of the treatment liquid would make it difficult to stably manufacture semiconductor wafers. On the other hand, in the smoothing agent for filtration containing a plurality of oxidizing agents, for example, containing a hypochlorite ion in addition to a hypobromite ion, a bromide ion losing its oxidizing power is oxidized with a hypochlorite ion and changes into a hypobromite ion. This makes it possible to prevent the decrease in the hypobromite ion concentration in the smoothing agent for filtration, and the etching rate is less likely to decrease also when the smoothing agent for filtration is reused.

For the reasons described above, in the smoothing agent for filtration according to an embodiment of the present invention, the agent containing a hypobromite ion, a hypochlorite ion preferably coexists in the smoothing agent for filtration. The concentration of the hypochlorite ion is not limited as long as it does not depart from the spirit of the present invention but is preferably 0.001 mol/L or more and 0.2 mol/L or less. The hypochlorite ion at a concentration of less than 0.001 mol/L cannot efficiently oxidize Br⁻, reducing the etching rate for ruthenium. On the other hand, adding the hypochlorite ion in an amount more than 0.2 mol/L would reduce the stability of the hypochlorite ion and promote decomposition of the hypobromite ion by the reaction between the hypochlorite ion and the hypobromite ion. Thus, this is not appropriate. The concentration of the hypobromite ion is more preferably 0.005 mol/L or more and 0.10 mol/L or less and most preferably 0.01 mol/L or more and 0.05 mol/L or less.

### (Additional Additive)

The smoothing agent for filtration according to an embodiment of the present invention can be blended with an additional additive that has been used in semiconductor treatment liquids in the art as long as it does not impair the object of the present invention. Examples of the additional additive that can be added include an acid, a metal anticorrosive, a water-soluble organic solvent, a fluorine compound, an oxidizing agent, a reducing agent, a complexing agent, a chelating agent, a surfactant, an antifoaming agent, a pH adjusting agent, and a stabilizing agent. An additive of these can be added alone, or a plurality of these additives can be added in combination.

To adjust the pH of the smoothing agent for filtration, an acid or an alkali can be added to the smoothing agent for filtration. For the alkali, an organic alkali is preferably used because it does not contain a metal ion, which is otherwise problematic in semiconductor manufacturing. In particular, the organic alkali is preferably tetraalkylammonium hydroxide and more preferably tetramethylammonium hydroxide because it provides a large number of hydroxide ions per unit weight and a high-purity product is readily available.

The smoothing agent for filtration according to an embodiment of the present invention can contain an alkali metal ion, an alkaline earth metal ion, and/or the like, which is derived from the additive or contained for the convenience of manufacturing the smoothing agent for filtration, or the like. However, an ion, such as an alkali metal ion and an alkaline earth metal of these, if remains on a semiconductor wafer, would lead to a decrease in the yield of a semiconductor device. Thus, the content of metal in the smoothing agent for filtration according to an embodiment of the present invention, specifically, the content of any metal selected, for example, from lithium, sodium, potassium, aluminum, magnesium, calcium, chromium, manganese, iron, nickel, cobalt, copper, silver, cadmium, barium, zinc, and lead is, on a mass basis, preferably 1 ppb or less, more preferably 0.5 ppb or less, even more preferably 0.2 ppb or less, and most preferably 0.1 ppb or less. **In** addition, among the above metals, the content of any one metal selected from iron, copper, and zinc is, on a mass basis, preferably 0.01 ppt or more and 1 ppb or less, more preferably 0.01 ppt or more and 0.5 ppb or less, even more preferably 0.01 ppt or more and 0.2 ppb or less, and most preferably 0.01 ppt or more and 0.1 ppb or less. Furthermore, ionic metals are described in the above as a metal that can be contained in the smoothing agent for filtration according to an embodiment of the present invention; however, the metal is not limited to these, and a non-ionic metal (particulate metal) can be contained. When a particulate metal is contained alone, its concentration is preferably in the above range. Moreover, when an ionic metal and a particulate metal are contained, their total is preferably in the above range.

Water contained in the smoothing agent for filtration according to an embodiment of the present invention is preferably water from which a metal ion, an organic impurity, a particulate particle, and/or the like is removed by distillation, ion exchange treatment, filtration treatment, adsorption treatment of various types, and/or the like, and particularly preferably pure water or ultrapure water. Such water can be obtained by a known method widely used in semiconductor manufacturing.

The smoothing agent for filtration according to an embodiment of the present invention is preferably stored at low temperature and/or protected from light. Storage at low temperature and/or protection from light can be expected to have an effect of preventing decomposition of the oxidizing agent and an onium ion in the smoothing agent for filtration. Furthermore, the stability of the smoothing agent for filtration can be maintained by storing the smoothing agent for filtration in a container filled with an inert gas to prevent carbon dioxide from entering. In addition, the inner surface of the container, that is, the surface to be in contact with the smoothing agent for filtration, is preferably formed of glass or an organic polymer material. This is because the container having an inner surface formed of glass or an organic polymer material can further reduce the entrance of impurities, such as a metal, a metal oxide, and/or an organic material.

The smoothing agent for filtration according to an embodiment of the present invention is a chemical solution in which capture of an onium salt by a filter is reduced in a filtration step included in a method of manufacturing a semiconductor device, and in other words, it can also be said to be an agent for reducing capture of an onium salt otherwise captured by a filter.

### (Method of Etching Semiconductor Wafer)

A semiconductor wafer to which the smoothing agent for filtration according to an embodiment of the present invention is applied when the smoothing agent is used in treatment a semiconductor contains at least one metal selected from Ru, Rh, Ti, Ta, Co, Cr, Hf, Os, Pt, Ni, Mn, Cu, Zr, La, Mo, and W. A metal of these is formed into a film on the semiconductor wafer by a method widely known in semiconductor manufacturing processes, for example, CVD, ALD, PVD, sputtering, or plating. The smoothing agent for filtration according to an embodiment of the present invention has an effect of preventing RuO₄ gas by containing an onium ion and thus can be suitably used particularly for ruthenium among these metals. Ruthenium is not limited to metallic ruthenium, contains 70 atom% or more of ruthenium, and includes a ruthenium alloy, a ruthenium oxide (such as ruthenium dioxide and diruthenium trioxide), a nitride, an oxynitride, an intermetallic compound, an ionic compound, and a complex.

The smoothing agent for filtration according to an embodiment of the present invention is brought into contact with a semiconductor wafer, and the semiconductor wafer can be etched accordingly. That is, a method of etching a semiconductor wear according to an embodiment of the present invention includes a step of bringing the smoothing agent for filtration into contact with a semiconductor wafer.

The smoothing agent for filtration according to an embodiment of the present invention can be used as it is as a semiconductor treatment liquid, and the smoothing agent for filtration containing the oxidizing agent described above, can be suitably used as an etching solution for a semiconductor wafer. In the case of using the smoothing agent for filtration as an etching liquid, the conditions described above can be applied to the type of oxidizing agent and the concentration of the oxidizing agent in the smoothing agent for filtration. In addition, those described above can also be applied to other conditions of the smoothing agent for filtration.

The method of etching will be described by taking as an example a wet-etching step of ruthenium using the smoothing agent for filtration according to an embodiment of the present invention. First, a substrate made of a semiconductor (e.g., Si) is prepared. The prepared substrate is oxidized to form a silicon oxide film on the substrate. Then, an interlayer insulating film made of a low dielectric constant (Low-k) film is formed, and via holes are formed at predetermined intervals. After formation of the via holes, ruthenium is formed into a film by thermal CVD. This ruthenium film is etched using the smoothing agent for filtration according to an embodiment of the present invention. This enables formation of a ruthenium wiring with excellent surface smoothness in each via hole while preventing RuO₄ gas generation.

The temperature when ruthenium is etched using the smoothing agent for filtration according to an embodiment of the present invention as a semiconductor treatment liquid is not particularly limited but is determined in view of the etching rate of ruthenium, the RuO₄ gas generation amount, and/or the like. Treatment at high temperature would increase the RuO₄ gas amount and reduce the stability of a hypobromite ion. On the other hand, treatment at lower temperatures would tend to reduce the etching rate. For such reasons, the temperature for etching ruthenium is preferably from 10°C to 90°C, more preferably from 15°C to 60°C, and most preferably from 25°C to 45°C.

### (Method of Manufacturing Semiconductor Device)

A method of manufacturing a semiconductor device according to an embodiment of the present invention includes steps of:
filtering the above smoothing agent for filtration; and
subjecting the smoothing agent for filtration after the filtration to etching of a semiconductor wafer. The smoothing agent for filtration according to an embodiment of the present invention can be used as it is in the method of manufacturing a semiconductor device. In addition, to the etching step, the conditions described above can be applied as they are. The metal to be etched can be the same as that described above. To etch a semiconductor wafer, the smoothing agent for filtration preferably contains the oxidizing agent described above. The conditions described above can be applied to the type of oxidizing agent and the concentration of the oxidizing agent in the smoothing agent for filtration. Furthermore, the surface tension of the smoothing agent for filtration at 25°C is preferably 60 mN/m or more and 75 mN/m or less, and its preferred range is the same as the conditions described above. Moreover, those described above can also be applied to other conditions of the smoothing agent for filtration.

With reference to FIG. 1, when a semiconductor device is produced, the smoothing agent for filtration has an opportunity to pass through filters 1 and 2 or 3. When a valve 10 of FIG. 1 is closed and a valve 9 is opened, a chemical solution in a chemical cabinet 6 is filtered by passing through the filters 1 and 2 by driving a pump 4. To remove impurities in the chemical solution in the chemical cabinet 6 as much as possible, the filtration step of passing the chemical solution through the filters 1 and 2 can be performed a plurality of times. The number of the filter(s) through which the chemical solution is passed in one filtration step is, for example, 1 or more and can be 2, 3, or 4 or more.

When the valve 10 in FIG. 1 is opened, the chemical solution in the chemical cabinet 6 is supplied to an etching table 8 by driving the pump 4, and a semiconductor wafer is etched. To replenish the chemical solution in the chemical cabinet 6, the chemical solution in a chemical solution replenishing unit is passed through a filter 3 by driving a pump 5 and is replenished into the chemical cabinet 6.

The chemical solution described here can be the smoothing agent for filtration itself or can be a chemical solution obtained by adding the smoothing agent for filtration to a chemical solution different from the smoothing agent for filtration. When the smoothing agent for filtration is added to a chemical solution different from the smoothing agent for filtration, the surface tension of the chemical solution after mixing is adjusted to the range described above. The preferred range of the surface tension of the chemical solution after mixing is also the same as the range described above.

The method of manufacturing a semiconductor device can include a known step used in a method of manufacturing a semiconductor device, such as one or more steps selected from a wafer fabrication step, an oxide film formation step, a transistor formation step, a wiring formation step, and a CMP step.

**In** addition, the method of manufacturing a semiconductor device according to an embodiment of the present invention can include, as one step, a method of recovering a metal from a used semiconductor treatment liquid described later. Specifically, the method of manufacturing a semiconductor device according to an embodiment of the present invention can be a manufacturing method of recovering a metal in a treatment liquid by including a step of recovering a treatment liquid after etching treatment of a semiconductor wafer, a step of adding a metal recovery agent described later to the recovered treatment liquid, and a step of filtering the treatment liquid to which the metal recovery agent has been added.

### (Method of Manufacturing Smoothing Agent for Filtration)

In another embodiment of the present invention, there is provided a method of manufacturing a smoothing agent for filtration. In the method of manufacturing a smoothing agent for filtration, at least an onium ion and water are mixed, and the mixture is adjusted to have a surface tension at 25°C of 60 mN/m or more and 75 mN/m or less (25°C). In the manufacturing method of the present embodiment, the conditions of the type and concentration of the onium ion used in the smoothing agent for filtration described above can be applied as they are. The surface tension of the solution containing an onium ion and water can be adjusted, for example, by adjusting the type and concentration of the onium ion. To the preferred range of the surface tension of the smoothing agent for filtration after preparation, the range described above can be applied as it is. In the case of adding an oxidizing agent to the smoothing agent for filtration, the oxidizing agent can be added at the time of mixing an onium ion and water, or the oxidizing agent can be added to a solution obtained by mixing an onium ion and water in advance. The conditions described above can be applied as they are to the type and concentration of the oxidizing agent. In addition, those described above can also be applied to the conditions of an additional additive contained in the smoothing agent for filtration.

### (Regeneration Method For Used Semiconductor Treatment Liquid)

Another embodiment of the present invention includes a step of adding the above smoothing agent for filtration to a used semiconductor treatment liquid (hereinafter also referred to simply as the regeneration method). In the regeneration method according to an embodiment of the present invention, a used semiconductor treatment liquid is a target for regeneration. Here, the used semiconductor treatment liquid refers to, for example, a chemical solution that has been used at least once in treatment, such as etching, in manufacturing a semiconductor wafer. Thus, the used semiconductor treatment liquid can contain an oxidizing agent. Examples of the oxidizing agent include the types mentioned in the description of the smoothing agent for filtration.

In addition, the surface tension at 25°C of the regenerated semiconductor treatment liquid after the addition of the smoothing agent for filtration can be adjusted to 60 mN/m or more and 75 mN/m or less. Adjusting to such a surface tension enables prevention of the decrease in an onium ion in the filtration step in the case of subjecting the regenerated semiconductor treatment liquid to the method of manufacturing a semiconductor device. To adjust the surface tension of the regenerated semiconductor treatment liquid, the type and concentration of the onium ion contained in the smoothing agent for filtration to be added can be adjusted. To the type of onium ion in the smoothing agent for filtration to be added, the conditions described in the section of the smoothing agent for filtration can be applied as they are. In addition, the concentration of the onium ion in the smoothing agent for filtration to be added is preferably adjusted to adjust the concentration of the onium ion contained in a chemical solution after regeneration to the range described for the above smoothing agent for filtration.

### (Composition for Polishing)

A composition for polishing according to an embodiment of the present invention is characterized by containing one or more onium ions selected from the group consisting of onium ions represented by formulas (1) to (6) below and can polish a semiconductor wafer containing, but not limited to, a metal or a metal oxide to be flat and smooth in a state of maintaining a high polishing rate. 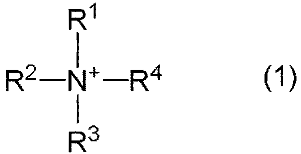 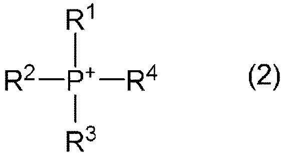 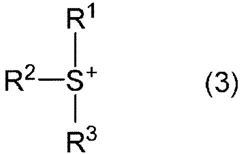 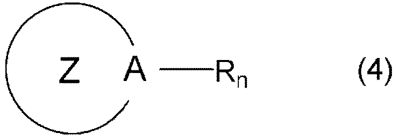 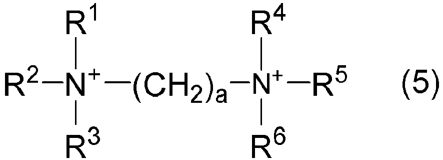 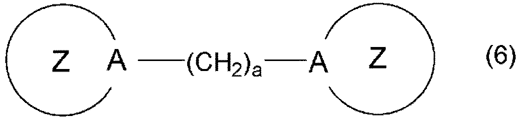 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
the counter anion to the onium ion is a fluoride ion, a chloride ion, a bromide ion, an iodide ion, a hydroxide ion, a nitrate ion, a phosphate ion, a sulfate ion, a hydrogensulfate ion, a methanesulfate ion, a perchlorate ion, a chlorate ion, a chlorite ion, a hypochlorite ion, an orthoperiodate ion, a metaperiodate ion, an iodate ion, an iodite ion, a hypoiodite ion, an acetate ion, a carbonate ion, a hydrogen carbonate ion, a fluoroborate ion, or a trifluoroacetate ion,
A is an ammonium ion or a phosphonium ion,
Z is an aromatic group or alicyclic group optionally containing a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

Blending the composition for polishing with such an onium ion allows an onium ion produced by dissociation of the onium ion to interact with a metal, a metal oxide, and/or the like to be polished, and a smooth polished surface is obtained accordingly. Examples of such an onium ion include the compounds described for the above smoothing agent for filtration according to an embodiment of the present invention, and the preferred range of the onium ion concentration is also the same.

The surface tension of the composition for polishing according to an embodiment of the present invention at 25°C can be 60 mN/m or more and 75 mN/m or less. The surface tension of the composition for polishing at 25°C can be 68 mN/m or more and 75 mN/m or less or 71 mN/m or more and 73 mN/m or less. With the surface tension of the composition for polishing in these ranges, a sufficient polishing rate can be obtained for the object to be polished, and the surface smoothness of the object to be polished can be finished in a preferred state.

The composition for polishing according to an embodiment of the present invention can contain an oxidizing agent. The oxidizing agent is not particularly limited, but in the case of polishing a substance with high hardness and high chemical stability, to obtain a sufficiently high polishing rate, a hypohalite ion with high oxidizing power, such as, in particular, a hypochlorite ion or a hypobromite ion is preferably selected. In this case, the counter ion (cation) is preferably a quaternary ammonium ion, such as a tetramethylammonium ion, in terms of being able to reduce the content of the metal. In the case of adding a hypohalite ion as an oxidizing agent, its concentration is not particularly limited, but with too low a concentration, the polishing rate would decrease, and with too high a concentration, a concentration change due to the decomposition of the hypohalite ion would increase. For such reasons, in the case of adding a hypohalite ion as an oxidizing agent, the concentration of the hypohalite ion is preferably 0.001 mol/L or more and 0.20 mol/L or less, more preferably 0.005 mol/L or more and 0.20 mol/L or less, and most preferably 0.01 mol/L or more and 0.10 mol/L or less. Also in the case where the hypohalite ion is one or more selected from a hypochlorite ion and a hypobromite ion, the same concentration range can be applied.

In addition, each concentration of a halogenate ion, a halogenite ion, and a halide ion produced by consumption of a hypohalite ion by polishing or natural decomposition during storage is preferably 0.00001 mol/L or more and 0.10 mol/L or less, more preferably 0.00001 mol/L or more and 0.02 mol/L or less, and most preferably 0.00001 mol/L or more and 0.01 mol/L or less.

### (pH)

The pH of the composition for polishing according to an embodiment of the present invention is preferably 7 or more and 14 or less from the viewpoint of polishing characteristics and stability. At a pH of less than 7, the polishing rate may decrease and become unstable. For example, in the composition for polishing containing a hypohalite ion as an oxidizing agent, the hypohalite ion decomposes at a pH of less than 7. In addition, at a pH of less than 7, metal-containing particles may be more likely to remain on the semiconductor wafer surface, thus tending to increase the amount of metal remaining on the wafer after polishing. From that point, the pH is preferably 7 or more. Furthermore, in the case of using colloidal silica as an abrasive grain, the colloidal silica may dissolve at a pH of 13 or more. For these reasons, the pH is preferably 7 or more and 14 or less, more preferably 9 or more and 13 or less, and most preferably 11 or more and 12.5 or less.

### (Polishing Agent)

For the composition for polishing according to an embodiment of the present invention containing an abrasive grain, a known abrasive grain can be used without particular limitation. Examples of the preferred abrasive grain include a silicon oxide (silica) particle, a diamond particle, a cerium oxide (ceria) particle, an aluminum oxide (alumina) particle, a zirconium oxide (zirconia) particle, and a titanium oxide (titania) particle. The concentration of the polishing agent of these is not particularly limited but is preferably from 0.02 to 10.0 mass% and more preferably from 0.5 to 5.0 mass% because with too low a concentration, the polishing rate would decrease, and with too high a concentration, abrasive grains would aggregate and cause deterioration of the surface smoothness.

### (Method of Polishing)

A method of polishing using the composition for polishing according to an embodiment of the present invention can be performed using a single-sided or double-sided polishing machine. An example of the polishing apparatus that can be used is a polishing apparatus including a rotary table for fixing a surface plate, a wafer holding portion for holding a wafer for a semiconductor, the wafer to be polished, and a pressure portion having a rotating mechanism for pressing the held wafer against a polishing surface of the surface plate with a given polishing load while rotating the wafer.

For example, polishing can be carried out by a method in which the composition for polishing according to an embodiment of the present invention to which an abrasive grain is added is put by applying, spraying, dropping, or the like onto a semiconductor wafer to be polished, the wafer is brought into contact with a polishing pad (sheet) containing no abrasive particles, and the wafer is polished by relative motion of the wafer and the polishing pad, or by a method in which the composition for polishing according to an embodiment of the present invention is put by applying, spraying, dropping, or the like onto a semiconductor wafer to be polished, the wafer is brought into contact with a polishing pad (sheet) on which abrasive particles are fixed, and the wafer is polished by relative motion of the wafer and the polishing pad. The semiconductor wafer to be polished using a polishing liquid according to an embodiment of the present invention is, for example, a semiconductor wafer containing Ru, Rh, Ti, Ta, Co, Cr, Hf, Os, Pt, Ni, Mn, Cu, Zr, La, Mo, W, and/or the like as a polishing object.

### (Additional Component)

The composition for polishing according to an embodiment of the present invention can appropriately contain a lubricant, a viscosity-imparting agent, a viscosity modifier, a rust inhibitor, and/or the like as necessary as long as it does not depart from the spirit of the present invention. For example, the composition for polishing can be prepared by mixing an abrasive grain (silica), an oxidizing agent (hypobromite ion), a pH adjusting agent (tetramethylammonium hydroxide), and ultrapure water.

### (Metal Recovery Agent)

A metal recovery agent according to an embodiment of the present invention is characterized by containing one or more onium ions selected from onium ions to coordinate with a metal oxide ion and a metal hydroxide ion. The onium ion forms an ion complex with a metal oxide ion or a metal hydroxide ion and produces an insoluble salt. Recovering the insoluble salt by filtration or the like makes it possible to recover the metal.

The onium ion to coordinate with a metal oxide ion or a metal hydroxide ion is preferably a phosphonium ion, a sulfonium ion, or an ammonium ion, and more preferably a phosphonium ion or an ammonium ion, which forms a stable ion complex with a metal oxide ion. More specific examples include one or more selected from the group consisting of the onium ions represented by formulas (1) to (6) described in the section of the smoothing agent for filtration.

The metal oxide ion or the metal hydroxide ion is a metal oxide or a metal hydroxide ion having a negative charge in a solution and specifically an oxide ion or a hydroxide ion of Ru, Ta, Co, Cr, Os, Ni, Mn, Cu, Zr, Mo, or W. Addition of the onium ion to a solution containing an ion of these forms an ion complex with a metal oxide ion or a metal hydroxide ion and produces an insoluble salt.

The type of onium ion that can be used is the same as that described for the smoothing agent for filtration. Examples of the type of counter ion of the onium ion include the same as those described for the smoothing agent for filtration. The metal recovery agent contains the onium ion preferably in a concentration of 1 mass ppm or more and 50 mass% or less, more preferably in a concentration of 10 mass ppm or more and 10 mass% or less, even more preferably in a concentration of 50 mass ppm or more and 10000 mass ppm or less, and most preferably 100 mass ppm or more and 5000 mass ppm or less. This concentration range can be similarly applied to the case where the onium ion is one or more selected from the group consisting of the onium ions represented by formulas (1) to (6).

The surface tension of the metal recovery agent at 25°C can be 60 mN/m or more and 75 mN/m or less. The surface tension of the composition for polishing at 25°C can be 68 mN/m or more and 75 mN/m or less or can be 71 mN/m or more and 73 mN/m or less. The surface tension of the metal recovery agent in these ranges allows the used metal recovery agent after metal recovery by filtration or the like to be used again as the metal recovery agent.

### (Method of Recovering Metal from Used Semiconductor Treatment Liquid)

Another embodiment of the present invention is a method of recovering a metal from a used semiconductor treatment liquid (hereinafter also referred to simply as the recovery method) including a step of adding the metal recovery agent to a used semiconductor treatment liquid. The recovery method according to an embodiment of the present invention is directed to recovery of a metal from a used semiconductor treatment liquid. Here, the used semiconductor treatment liquid refers to, for example, a chemical solution that has been used at least once in treatment, such as etching, in manufacturing a semiconductor wafer. Thus, the used semiconductor treatment liquid can contain an oxidizing agent. Examples of the oxidizing agent include the types mentioned in the description of the smoothing agent for filtration. Adding the metal recovery agent to a used semiconductor treatment liquid precipitates an insoluble salt containing a metal, and the metal can be recovered through a step of filtering the insoluble salt. The filter used for filtering metal is preferably, for example, a filter made of an organic polymer material or an inorganic material. For example, it is possible to use a filtration filter made of polyolefin (made of polypropylene, polyethylene, or ultrahigh molecular weight polyethylene), made of polysulfone, made of cellulose acetate, made of polyimide, made of polystyrene, a fluorine-based resin, and/or quartz fiber. The fluororesin is not particularly limited as long as it is a resin (polymer) containing a fluorine atom, and a known fluororesin can be used. Examples include poly(tetrafluoroethylene), poly(chlorotrifluoroethylene), poly(vinylidene fluoride), tetrafluoroethylene-hexafluoropropylene copolymers, tetrafluoroethylene-perfluoroalkyl vinyl ether copolymers, tetrafluoroethylene-ethylene copolymers, chlorotrifluoroethylene-ethylene copolymers, and cyclic polymers of perfluoro(butenyl vinyl ether).

The pore size of the filtration filter is not particularly limited, but for removing coarse particles, a filtration filter with a pore size of 1 µm or more or a microfiltration filter can be used. On the other hand, for removing fine particles, a microfiltration filter with a pore size of 0.001 µm or more and less than 1 µm, an ultrafiltration filter, or a nanofiltration membrane can be used.

In the method of manufacturing a semiconductor device, the method including the recovery method above as a series of steps, for example, the following steps are combined:
a step of recovering a used semiconductor treatment liquid,
a step of adding the metal recovery agent to the recovered treatment liquid, and
a step of filtering the used semiconductor treatment liquid to which the metal recovery agent has been added. In addition, it is also possible to add the metal recovery agent to a semiconductor treatment liquid in advance, precipitate an insoluble salt containing a metal in a used semiconductor treatment liquid, and recover the insoluble salt by a subsequent filtration step. In these cases, the used semiconductor treatment liquid after metal recovery can also be reused as a semiconductor treatment liquid.

The salt of the metal oxide ion or the metal hydroxide ion and the onium ion recovered by the filtration filter can be eluted into a solvent by passing the solvent capable of dissolving the salt through the filtration filter. Examples of the solvent capable of dissolving the salt include, but are not limited to, water, acids, alkalis, alcohols, ethers, ketones, nitriles, amines, amides, carboxylic acids, and aldehydes. Examples of such solvents include, but of course are not limited to, hydrochloric acid, sulfuric acid, nitric acid, ammonia water, tetramethylammonium hydroxide, ethyltrimethylammonium hydroxide, tetraethylammonium hydroxide, tetrapropylammonium hydroxide, tetrabutylammonium hydroxide, methanol, ethanol, propanol, butanol, tetrahydrofuran, 1,4-dioxane, acetone, 4-methyl-2-pentanone, acetylacetone, acetonitrile, propionitrile, butyronitrile, isobutyronitrile, benzonitrile, ethylenediamine, pyridine, formamide, N-methylformamide, N,N-dimethylformamide, N-methylacetamide, N,N-dimethylacetamide, N-methylpropionamide, dimethyl sulfoxide, sulfolane, dimethylthioformamide, N-methylthiopyrrolidone, nitromethane, nitrobenzene, ethyl acetate, methyl acetate; monocarboxylic acids, such as acetic acid, formic acid, lactic acid, glycolic acid, 2,2-bis(hydroxymethyl)propionic acid, gluconic acid, α-glucoheptonic acid, heptynoic acid, phenylacetic acid, phenylglycolic acid, benzilic acid, gallic acid, cinnamic acid, naphthoic acid, anisic acid, salicylic acid, cresotic acid, acrylic acid, and benzoic acid; malic acid, adipic acid, succinic acid, maleic acid, tartaric acid, oxalic acid, glutaric acid, malonic acid, 1,3-adamantanedicarboxylic acid, diglycolic acid, and phthalic acid. The salt captured in the pores of the filtration filter can be dissolved and removed by passing the solvent through the filtration filter, thus allowing the regeneration of the filtration filter.

### Examples

The present invention will be more specifically described below by examples, but the present invention is not limited to these Examples.

### (Evaluation of Surface Tension)

The surface tensions of smoothing agents for filtration which were not subjected to filtration described later were measured using a surface tensiometer (DY300, available from Kyowa Interface Science Co., Ltd.). The measurement was performed in accordance with "Test Method by Wilhelmy Surface Tensiometer" of JIS2241.

### (Filtration of Smoothing Agent for Filtration)

In a PFA bottle with a volume of 5 L, 2 L of a smoothing agent for filtration was filled and passed through a filter with a filtration accuracy of 5 nm (SWD03UG54E71-K13C, available from Nihon Pall Ltd.) using a diaphragm type liquid feed pump (18S NF100TT, available from KNF Corporation). The solution passed through the filter was circulated to the PFA bottle and repeatedly passed through the filter until the total amount of 2 L of the solution passed through the filter 100 times. The resulting solution was recovered as a filtered smoothing agent for filtration.

### (Evaluation of Residual Rate of Onium Ion after Filtration)

The onium ion concentrations in the smoothing agent for filtration before and after filtration were evaluated using a liquid chromatography-mass spectrometer (Xevo QT of MS, available from Waters Corporation), and the residual rate of the onium salt after filtration was evaluated according to the following criteria. In any example, evaluations A to C are acceptable levels, and an evaluation D is an unacceptable level.
A: from 100 to 95%
B: less than 95% to 80%
C: less than 80% to 60% (acceptable level)
D: < 60%

### (Evaluation of Etching Rate)

First, an oxide film was formed on a silicon wafer using a batch-type thermal oxidation furnace, and a 1200 Å (±10%) film of ruthenium was formed on the oxide film using a sputtering method. The sheet resistance was measured with a four-probe resistance meter (Loresta-GP, available from Mitsubishi Chemical Analytech Co., Ltd.) and converted to a film thickness, and this was used as the ruthenium film thickness before etching treatment. Then, 60 mL of the smoothing agent for filtration after filtration obtained above was placed in a fluororesin container with a lid (94.0-mL PFA container, available from As One Corporation). A ruthenium film piece with a size of 10 x 20 mm was immersed in a smoothing agent for filtration at 30°C for 1 minute. The sheet resistance was also similarly measured with the four-probe resistance meter after etching treatment and converted to a film thickness, and this was used as the ruthenium film thickness after etching treatment. A value obtained by dividing the amount of change in the film thickness before and after treatment by the immersion time was calculated as the etching rate and evaluated according to the following criteria. In any example, evaluations A to C are acceptable levels, and an evaluation D is an unacceptable level.
A: > 50 Å/min
B: from 50 to 20 Å/min
C: less than 20 Å/min to 10 Å/min (acceptable level)
D: failed to etch

### (Quantitative Analysis of RuO₄ Gas)

The generated amount of RuO₄ gas was measured using an ICP-OES. In a sealed container, 5 mL of the smoothing agent for filtration after filtration obtained above was placed, and one 10 x 20 mm ruthenium film obtained by forming a ruthenium film with a film thickness of 1200 Å was immersed at 30°C until all the ruthenium was dissolved. Then, air was flowed into the sealed container, the gas phase in the sealed container was bubbled into a container containing an absorbing liquid (1 mol/L NaOH), and the RuO₄ gas generated during immersion was trapped in the absorbing liquid. The dissolution of all the ruthenium on the Si wafer immersed in the smoothing agent for filtration was confirmed by measuring sheet resistances each before and after immersion with a four-probe resistance meter (Loresta-GP, available from Mitsubishi Chemical Analytech Co., Ltd.) and converting the sheet resistance to a film thickness. The ruthenium amount in the absorbing liquid was measured with an ICP-OES (iCAP6500 DUO, available from Thermo Fisher Scientific K.K.), converted to the RuO₄ gas amount, and evaluated according to the following criteria. In any example, evaluations A to C are acceptable levels, and an evaluation D is an unacceptable level.
A: < 5 µg/cm²
B: from 5 to less than 10 µg/cm²
C: from 10 µg/cm² to 40 µg/cm² or less (acceptable level)
D: > 40 µg/cm²

### (Evaluation of Surface Smoothness after Etching)

The ruthenium surface before and after etching was observed with a field emission scanning electron microscope (JSM-7800F Prime, available from JEOL Ltd.) to determine the presence or absence of surface roughening and evaluated according to the following criteria. Surface roughening was evaluated as A to D in the order of less to more roughening, and in any example, evaluations of A to C are acceptable levels, and an evaluation D is an unacceptable level.
A: No surface roughening is observed
B: Surface roughening is slightly observed
C: Roughening is observed on the entire surface, but the roughness is shallow
D: Roughening is observed on the entire surface, and the roughness is deep

### (Stability Evaluation During Reuse of Smoothing Agent for Filtration)

In a fluororesin container with a lid (94.0-mL PFA container, available from As One Corporation), 80 mL of the smoothing agent for filtration after filtration obtained above was placed. A 10 x 10 mm ruthenium film obtained by forming a ruthenium film with a film thickness of 1200 Å was immersed in the smoothing agent for filtration at 30°C until all the ruthenium film was dissolved. Of the smoothing agent for filtration in which the ruthenium film was dissolved, 40 mL was used, and etching rate 1 was evaluated according to the method described above. The remaining 40 mL was stored at 30°C for one week, and etching rate 2 was evaluated in the same manner. A value obtained by dividing etching rate 2 by etching rate 1 was defined as the stability of the etching rate when the smoothing agent for filtration was reused, and was evaluated according to the following criteria. No change between etching rate 1 and etching rate 2 means that the performance of the smoothing agent for filtration after reuse is maintained. In addition, even if the etching rate changes, evaluations A to C are acceptable levels, and evaluation D is an unacceptable level.
A: 0.9 or more and 1.1 or less
B: more than 1.1 and 1.2 or less or more than 0.8 and less than 0.9
C: more than 1.2 and 1.3 or less or more than 0.7 and less than 0.8 (acceptable level)
D: more than 1.3 or 0.7 or less

### Method of calculating hypobromite ion and hypochlorite ion concentrations

The hypobromite ion and hypochlorite ion concentrations were measured using an ultraviolet-visible spectrophotometer (UV-2600, available from Shimadzu Corporation). A calibration curve was produced using aqueous solutions of hypobromite ions and hypochlorite ions with known concentrations, and the hypobromite ion and hypochlorite ion concentrations in the manufactured smoothing agent for filtration were determined. The hypobromite ion concentration was determined from measurement data when the absorption spectrum stabilized after mixing a bromine-containing compound, an oxidizing agent, and a base compound.

### <Examples 1 to 15 and Comparative Examples 1 to 3>

### (Manufacturing of Trimethylammonium Hypochlorite Solution)

In a 2-L glass three-necked flask (available from Cosmos Bead Co., Ltd.), 209 g of a 25 mass% tetramethylammonium hydroxide aqueous solution was mixed with 791 g of ultrapure water, and a 5.2 mass% tetramethylammonium hydroxide aqueous solution with a CO₂ content of 0.5 ppm. The pH at this time was 13.8.

A stirring bar (30 mm in total length x 8 mm in diameter, available from As One Corporation) was then placed in the three-necked flask, and a thermometer protecting tube (bottom-sealed type, available from Cosmos Bead Co., Ltd.) and a thermometer were placed in one opening. From another opening, a PFA tube (F-8011-02, available from Flon Industry) connected to a chlorine gas cylinder and a nitrogen gas cylinder in a state where the chlorine gas and the nitrogen gas can be freely switched was inserted, and the end of the PFA tube was immersed in the bottom of the solution. The remaining one opening was connected to a gas-washing bottle (gas-washing bottle, model No. 2450/500, available from As One Corporation) filled with a 5 mass% sodium hydroxide aqueous solution. Then, nitrogen gas with a carbon dioxide concentration of less than 1 ppm was flowed from the PFA tube at 0.289 Pa·m³/sec (when converted to 0°C) for 20 minutes, and carbon dioxide in the gas phase was purged. At this time, the carbon dioxide concentration in the gas phase was 1 ppm or less.

Then, a magnetic stirrer (C-MAG HS10, available from As One Corporation) was placed in the bottom portion of the three-necked flask and rotated at 300 rpm to stir the contents, and while the periphery of the three-necked flask was cooled with ice water, chlorine gas (specification purity 99.4%, available from Fujiox Co., Ltd.) was supplied at 0.059 Pa·m³/sec (when converted to 0°C) for 180 minutes, and a mixed solution of a tetramethylammonium hypochlorite aqueous solution (oxidizing agent; 3.51 mass% equivalent, 0.28 mol/L) and tetramethylammonium hydroxide (0.09 mass% equivalent, 0.0097 mol/L) was obtained. At this time, the solution temperature during the reaction was 11°C.

### (Manufacturing of Smoothing Agent for Filtration)

Given amounts of tetramethylammonium bromide (97 mass%, available from Tokyo Chemical Industry Co., Ltd.), an onium salt, a high-purity hydrochloric acid (available from Kanto Chemical Co., Inc.), and ultrapure water were mixed with the tetramethylammonium hypochlorite solution obtained by the above operation, and a smoothing agent for filtration with a composition shown in Table 1 was obtained.

### (Evaluation)

The etching rate of ruthenium, the generated amount of RuO₄ gas, the stability of the etching rate, the residual rate of the onium salt after filtration, and the surface smoothness were evaluated by the methods described above using the manufactured smoothing agent for filtration.

The compositions of the treatment liquids (smoothing agents for filtration) and each evaluation result are shown in Table 1. As shown in Table 1, in Comparative Examples 1 to 3, the onium salt concentration was significantly reduced by the filtration step and the surface smoothness was out of the acceptable range. Thus, all of the etching rate, the surface smoothness, the RuO₄ gas amount, and the stability could not be satisfied. On the other hand, it was confirmed that the smoothing agent for filtration of the present examples satisfied all of these evaluation items. In Examples 8 to 12, the effect of adding hypochlorite ion or phosphonium salt to the smoothing agent for filtration improved the stability of the treatment liquid during reuse. On the other hand, in Comparative Example 3, in which a phosphonium salt was also added, the surface tension was low, and the phosphonium salt was removed by filtration, and thus the effect of improving the stability was not observed.

**[Table 1-1]**

| | Onium salt | Oxidizing agent | pH | Surface tension [mN/m] | Onium salt residual rate after filtration | Etching rate | Surface smoothness | RuO₄ gas | Etching rate stability |
|---|---|---|---|---|---|---|---|---|---|
| Example 1 | Hexyltrimethylammonium chloride (500 ppm) | 0.03 mol/L Hypobromite ion | 12 | 66 | B | A | C | A | C |
| Example 2 | Diallyldimethylammonium chloride (500 ppm) | 0.03 mol/L Hypobromite ion | 12 | 71 | A | C | B | A | C |
| Example 3 | Benzyldimethylphenylammonium chloride (500 ppm) | 0.03 mol/L Hypobromite ion | 12 | 69 | A | A | A | A | C |
| Example 4 | Chlorocholine chloride (500 ppm) | 0.03 mol/L Hypobromite ion | 12 | 72 | A | C | C | A | C |
| Example 5 | 1,1'-(Decan-1,10-diyl)bis[4-aza-1-azoniabicyclo[2.2.2]octane] dibromide (500 ppm) | 0.03 mol/L Hypobromite ion | 12 | 71 | A | A | A | A | C |
| Example 6 | Benzyldimethylphenylammonium chloride (10 ppm) | 0.03 mol/L Hypobromite ion | 12 | 72 | A | A | C | B | C |
| Example 7 | Benzyldimethylphenylammonium chloride (10000 ppm) | 0.03 mol/L Hypobromite ion | 12 | 68 | A | B | A | A | C |
| Example 8 | Tributylhexylphosphonium bromide (500 ppm) | 0.03 mol/L Hypobromite ion | 12 | 66 | B | A | C | A | B |
| Example 9 | Tetraphenylphosphonium bromide (500 ppm) | 0.03 mol/L Hypobromite ion | 12 | 69 | A | B | B | A | A |
| Example 10 | Benzyldimethylphenylammonium chloride (500 ppm), tetraphenylphosphonium bromide (500 ppm) | 0.03 mol/L Hypobromite ion | 12 | 69 | A | B | A | A | A |

**[Table 1-2]**

| | | | | | | | | | |
|---|---|---|---|---|---|---|---|---|---|
| Example 11 | Benzyldimethylphenylammonium chloride (500 ppm) | 0.03 mol/L Hypobromite ion | 12 | 69 | A | A | A | A | B |
| | | 0.01 mol/L Hypochlorite ion | | | | | | | |
| Example 12 | Benzyldimethylphenylammonium chloride (500 ppm) | 0.03 mol/L Hypobromite ion | 12 | 69 | A | A | A | A | A |
| | | 0.1 mol/L Hypochlorite ion | | | | | | | |
| Example 13 | Benzyldimethylphenylammonium chloride (500 ppm) | 0.005 mol/L Hypobromite ion | 12 | 69 | A | C | A | A | C |
| Example 14 | Benzyldimethylphenylammonium chloride (500 ppm) | 0.1 mol/L Hypobromite ion | 12 | 69 | A | A | A | A | C |
| Example 15 | Tetraphenylphosphonium bromide (500 ppm) | 0.03 mol/L Orthoperiodate ion | 11 | 69 | A | B | B | B | A |
| Comparative Example 1 | Dodecyltrimethylammonium chloride (500 ppm) | 0.03 mol/L Hypobromite ion | 12 | 50 | D | A | D | B | C |
| Comparative Example 2 | Benzyldimethyltetradecylammonium chloride (500 ppm) | 0.03 mol/L Hypobromite ion | 12 | 40 | D | A | D | B | C |
| Comparative Example 3 | Tributylhexadecylphosphonium bromide (500 ppm) | 0.03 mol/L Hypobromite ion | 12 | 30 | D | A | D | B | C |

### <Examples 16 to 18>

First, an oxide film was formed on a silicon wafer using a batch-type thermal oxidation furnace, and a 1200 Å (± 10%) film of ruthenium was formed on the oxide film using a sputtering method. Then, 1800 g of colloidal silica (average particle size 80 nm, SiO₂ content 50%) and 2200 g of ultrapure water were added to 1000 g of a solution with similar compositions to those in Examples 10 to 12, and a composition for polishing was obtained. The surface tensions of the compositions for polishing were 68, 68, and 68 mN/m, respectively. Then, the ruthenium film-formed surface was polished using the prepared composition for polishing under the following conditions.
Polishing machine: EJ-380IN available from Engis Corporation
Polishing pressure: 500 gf/cm²
Polishing pad: SUBA-800, Nitta Haas Incorporated
Rotation speed of surface plate: 120 rpm
Supply amount of composition for polishing: 50 mL/min
Polishing time: 10 min

The sheet resistance was measured for ruthenium before and after polishing with a four-probe resistance meter (Loresta-GP, available from Mitsubishi Chemical Analytech Co., Ltd.) and converted to a film thickness, and the polishing rate of ruthenium was calculated.

Using each of the compositions for polishing described in Examples 16 to 18 resulted in a polishing rate of the ruthenium-containing wafer of 10 nm/min, revealing that a sufficient polishing rate was obtained. In addition, SEM observation was conducted on the polished surface and confirmed that good surface smoothness was obtained.

### <Examples 19 and 20>

A treatment liquid containing a hypobromite ion was prepared in the same manner as in Example 1 to have the composition in Table 2. A 10 x 10 mm ruthenium film obtained by forming a ruthenium film with a film thickness of 1200 Å was immersed in the resulting treatment liquid until all the ruthenium film was dissolved. A metal recovery agent with a composition shown in Table 2 was added to the treatment liquid in which the ruthenium film had been dissolved. The treatment liquid to which the metal recovery agent had been added was passed through a "Fluoroguard ATX Filter (pore size 0.05 µm)" made of polytetrafluoroethylene available from Nihon Entegris G.K. The onium ion concentration in the treatment liquid after filtration was measured in the same manner as in "Evaluation of Residual Rate of Onium Ion after Filtration". In addition, the ruthenium concentration in the treatment liquid after the filter filtration was measured with an ICP-OES (iCAP6500 DUO, available from Thermo Fisher Scientific K.K.).

### <Comparative Example 4>

A treatment liquid after filter filtration was prepared in the same manner as in Example 19 except that the metal recovery agent was not added to the treatment liquid. The ruthenium concentration in the treatment liquid after the filter filtration was measured with an ICP-OES (iCAP6500 DUO, available from Thermo Fisher Scientific K.K.).

**[Table 2]**

| | Oxidizing agent | Metal recovery agent | pH | Surface tension [mN/m] | Onium salt residual rate after filtration | Ruthenium residual rate after filtration |
|---|---|---|---|---|---|---|
| Example 19 | 0.03 mol/L Hypobromite ion | Tetraphenylphosphonium bromide (2000 ppm) | 12 | 69 | A | 0% |
| Example 20 | 0.03 mol/L Hypobromite ion | Butyldodecylphosphonium bromide (1000 ppm) | 12 | 45 | D | 10% |
| Comparative Example 4 | 0.03 mol/L Hypobromite ion | - | 12 | 73 | - | 100% |

The filter filtration using each of the metal recovery agents described in Examples 19 and 20 was able to recover metallic ruthenium. In addition, using the metal recovery agent with a high surface tension provided a good result for the onium salt residual rate after filtration, revealing that the metal recovery agent can be reused as a metal recovery agent. On the other hand, in Comparative Example 4, in which no metal recovery agent was added, it was confirmed that 100% of the ruthenium metal remained in the treatment liquid after filtration.

### Reference Signs List

1 Filter 1
2 Filter 2
3 Filter 3
4 Pump 1
5 Pump 2
6 Chemical cabinet
7 Chemical solution replenishing unit
8 Etching table
9 Valve 1
10 Valve 2

## Claims

1. A smoothing agent for filtration comprising an onium ion, wherein a surface tension at 25°C is 60 mN/m or more and 75 mN/m or less.

2. The smoothing agent for filtration according to claim 1, wherein the onium ion is one or more selected from the group consisting of onium ions represented by formula (1) to formula (6): 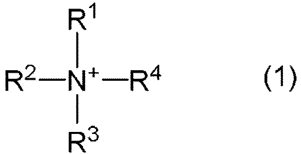 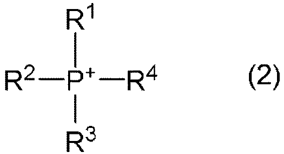 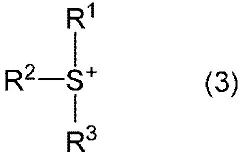 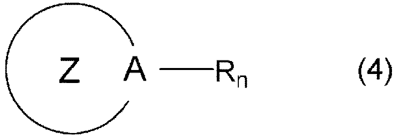 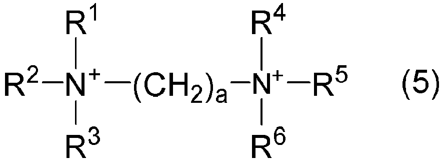 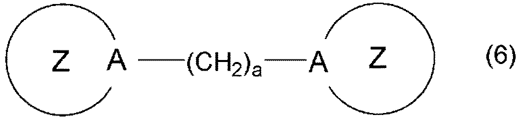 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally comprising a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

3. The smoothing agent for filtration according to claim 1 or 2, wherein a concentration of the onium ion is 1 mass ppm or more and 10000 mass ppm or less.

4. The smoothing agent for filtration according to any one of claims 1 to 3, further comprising 0.001 mol/L or more and 0.20 mol/L or less of a hypohalite ion.

5. The smoothing agent for filtration according to any one of claims 1 to 4, further comprising a periodate ion.

6. The smoothing agent for filtration according to any one of claims 1 to 5, wherein the smoothing agent for filtration is used in treatment a semiconductor wafer, and the semiconductor wafer comprises at least one metal selected from Ru, Rh, Ti, Ta, Co, Cr, Hf, Os, Pt, Ni, Mn, Cu, Zr, La, Mo, and W.

7. The smoothing agent for filtration according to any one of claims 1 to 5, wherein the semiconductor wafer comprises Ru.

8. A method of etching a semiconductor wafer, the method comprising a step of bringing the smoothing agent for filtration according to any one of claims 1 to 7 into contact with a semiconductor wafer.

9. A method of manufacturing a semiconductor device, the method comprising steps of:
filtering the smoothing agent for filtration according to any one of claims 1 to 7; and
subjecting the smoothing agent for filtration after the filtration to etching of a semiconductor wafer.

10. The method of manufacturing a semiconductor device according to claim 9, the method comprising the step of filtering the smoothing agent for filtration a plurality of times.

11. A regeneration method for a used semiconductor treatment liquid, the method comprising a step of adding the smoothing agent for filtration according to any one of claims 1 to 7 to a used semiconductor treatment liquid.

12. A composition for polishing comprising:
one or more selected from the group consisting of onium ions represented by formula (1) to formula (6) below; and
a hypohalite ion: 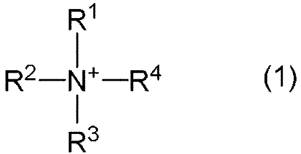 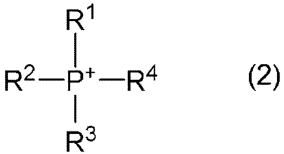 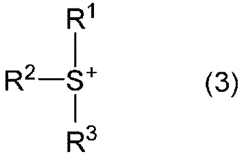 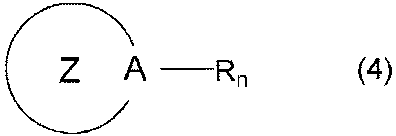 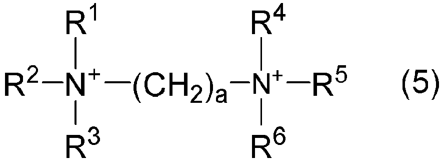 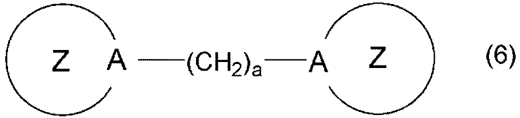
where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally comprising a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

13. A composition for polishing comprising the smoothing agent for filtration according to any one of claims 4 to 7.

14. A method of polishing a semiconductor wafer, the method comprising supplying a composition for polishing to a polishing pad comprising an abrasive grain or a polishing pad comprising no abrasive grain, and bringing a polishing target surface of a semiconductor wafer into contact with the polishing pad to polish the polishing target surface by relative motion between the polishing target surface and the polishing pad, wherein the composition for polishing according to claim 12 or 13 is used.

15. A metal recovery agent comprising an onium ion to coordinate with a metal oxide ion or a metal hydroxide ion.

16. The metal recovery agent according to claim 15, wherein the onium ion is one or more selected from a phosphonium ion and an ammonium ion.

17. A method of recovering a metal from a used semiconductor treatment liquid, the method comprising a step of adding the metal recovery agent according to claim 15 or 16 to a used semiconductor treatment liquid.

## Amended claims

### Amended claims in accordance with Rule 137(2) EPC.

1. (amended) A smoothing agent for filtration comprising an onium ion, wherein a surface tension at 25°C is 60 mN/m or more and 75 mN/m or less and comprising 0.001 mol/L or more and 0.20 mol/L or less of a hypohalite ion.

2. (amended) A smoothing agent for filtration comprising an onium ion, wherein a surface tension at 25°C is 60 mN/m or more and 75 mN/m or less and comprising 0.001 mol/L or more and 0.20 mol/L or less of a periodate ion

3. (amended) The smoothing agent for filtration according to claim 1 or 2, wherein the onium ion is one or more selected from the group consisting of onium ions represented by formula (1) to formula (6): 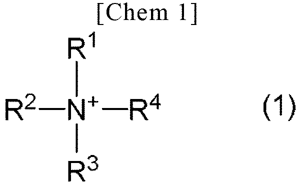 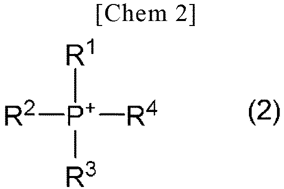 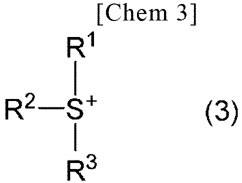 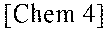 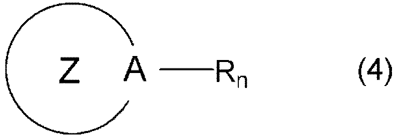 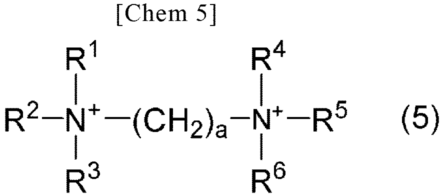 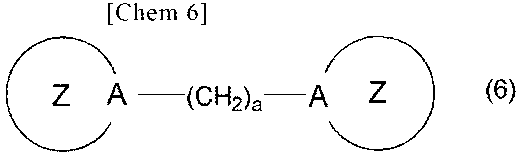 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally comprising a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9,
R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

4. (amended) The smoothing agent for filtration according to any one of claims 1 to 3, wherein a concentration of the onium ion is 1 mass ppm or more and 10000 mass ppm or less.

5. (deleted)

6. (amended) The smoothing agent for filtration according to any one of claims 1 to 4, wherein the smoothing agent for filtration is used in treatment a semiconductor wafer, and the semiconductor wafer comprises at least one metal selected from Ru, Rh, Ti, Ta, Co, Cr, Hf, Os, Pt, Ni, Mn, Cu, Zr, La, Mo, and W.

7. (amended) The smoothing agent for filtration according to any one of claims 1 to 4, wherein the semiconductor wafer comprises Ru.

8. (amended) A method of etching a semiconductor wafer, the method comprising a step of bringing the smoothing agent for filtration according to any one of claims 1 to 4, 6, and 7 into contact with a semiconductor wafer.

9. (amended) A method of manufacturing a semiconductor device, the method comprising steps of:
filtering the smoothing agent for filtration according to any one of claims 1 to 4, 6, and 7; and
subjecting the smoothing agent for filtration after the filtration to etching of a semiconductor wafer.

10. The method of manufacturing a semiconductor device according to claim 9, the method comprising the step of filtering the smoothing agent for filtration a plurality of times.

11. (amended) A regeneration method for a used semiconductor treatment liquid, the method comprising a step of adding the smoothing agent for filtration according to any one of claims 1 to 4, 6, and 7 to a used semiconductor treatment liquid.

12. A composition for polishing comprising:
one or more selected from the group consisting of onium ions represented by formula (1) to formula (6) below; and
a hypohalite ion: 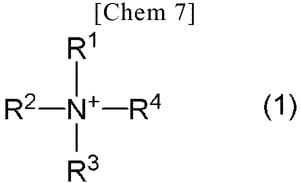 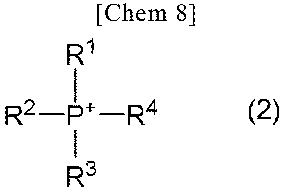 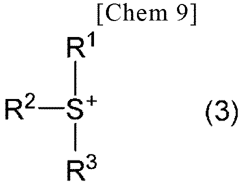 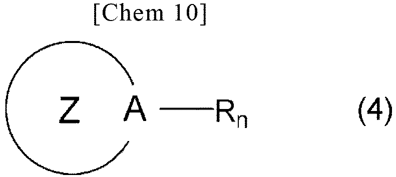 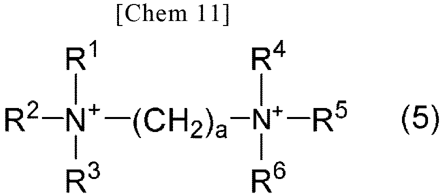 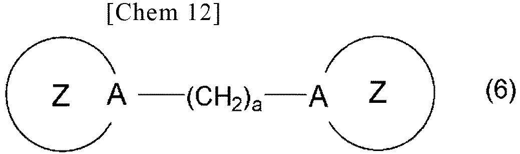 where in formula (1) to formula (6),
R¹, R², R³, R⁴, R⁵, and R⁶ are independently an alkyl group having a carbon number from 2 to 9, an allyl group, an aralkyl group having an alkyl group having a carbon number from 1 to 9, or an aryl group, in addition, in an aryl group of the aralkyl group and in a ring of the aryl group, at least one hydrogen is optionally substituted with fluorine, chlorine, an alkyl group having a carbon number from 1 to 9, an alkenyl group having a carbon number from 2 to 9, an alkoxy group having a carbon number from 1 to 9, or an alkenyloxy group having a carbon number from 2 to 9, and in these groups, at least one hydrogen is optionally substituted with fluorine, chlorine, bromine, or iodine,
A is an ammonium ion or a phosphonium ion,
Z is an aromatic group or alicyclic group optionally comprising a nitrogen, sulfur, or oxygen atom, and in the aromatic group or alicyclic group, carbon or nitrogen optionally has chlorine, bromine, fluorine, iodine, at least one alkyl group having a carbon number from 1 to 9, at least one alkenyloxy group having a carbon number from 2 to 9, an aromatic group optionally substituted with at least one alkyl group having a carbon number from 1 to 9, or an alicyclic group optionally substituted with at least one alkyl group having a carbon number from 1 to 9, R is chlorine, bromine, fluorine, iodine, an alkyl group having a carbon number from 1 to 9, an allyl group, an aromatic group optionally substituted with at least one alkyl group having a carbon number from 1 to 9, or an alicyclic group optionally substituted with at least one alkyl group having a carbon number from 1 to 9, n is an integer of 1 or 2 and represents the number of R, when n is 2, R moieties are optionally identical or different and optionally form a ring, and
a is an integer of 1 to 10.

13. (amended) A composition for polishing comprising the smoothing agent for filtration according to any one of claims 4, 6, and 7.

14. A method of polishing a semiconductor wafer, the method comprising supplying a composition for polishing to a polishing pad comprising an abrasive grain or a polishing pad comprising no abrasive grain, and bringing a polishing target surface of a semiconductor wafer into contact with the polishing pad to polish the polishing target surface by relative motion between the polishing target surface and the polishing pad, wherein the composition for polishing according to claim 12 or 13 is used.

15. A metal recovery agent comprising an onium ion to coordinate with a metal oxide ion or a metal hydroxide ion.

16. The metal recovery agent according to claim 15, wherein the onium ion is one or more selected from a phosphonium ion and an ammonium ion.

17. A method of recovering a metal from a used semiconductor treatment liquid, the method comprising a step of adding the metal recovery agent according to claim 15 or 16 to a used semiconductor treatment liquid.
